(19) Europäisches Patentamt
European Patent Office
Office européen des brevets

(11) **EP 2 901 502 B1**

(12) **EUROPEAN PATENT SPECIFICATION**

(45) Date of publication and mention
of the grant of the patent:
**19.10.2016  Bulletin 2016/42**

(21) Application number: **13792429.6**

(22) Date of filing: **26.09.2013**

(51) Int Cl.:
***H01L 33/50*** ***(2010.01)***

(86) International application number:
**PCT/IB2013/002123**

(87) International publication number:
**WO 2014/049422 (03.04.2014 Gazette 2014/14)**

(54) **LIGHT SOURCE WITH A PLEASANT LIGHT**

**LICHTQUELLE MIT EINEM ANGENEHMEN LICHT**

**SOURCE DE LUMIÈRE À LUMIÈRE AGRÉABLE**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **26.09.2012  IT UD20120164**

(43) Date of publication of application:
**05.08.2015  Bulletin 2015/32**

(73) Proprietor: **Martini S.p.A.**
**41033 Concordia Sulla Secchia (IT)**

(72) Inventor: **MARTINI, Giorgio**
**I-41033 Concordia Sulla Secchia (IT)**

(74) Representative: **Petraz, Davide Luigi et al
GLP S.r.l.
Viale Europa Unita, 171
33100 Udine (IT)**

(56) References cited:
**US-A1- 2007 170 842     US-A1- 2009 154 195
US-A1- 2009 261 710**

**Description**

FIELD OF THE INVENTION

The present invention concerns a light source which emits a pleasant light, that is, a light that is perceived as a natural light, neither warm nor cold, and in practice improves current standards used in internal or external lighting, such as, merely by way of example, incandescent, fluorescent and halogen light sources.
In particular, the invention concerns a light source such as LED Arrays, SingleChip or Multichip LEDs, OLEDs, remote phosphor LEDs, or similar or comparable LED light sources. To simplify, we shall refer hereafter to light sources of the LED Array type, although the inventive idea can be applied also to light sources of the SingleChip or Multichip LED type, OLEDs, remote phosphor LEDs or similar or comparable LED light sources.

BACKGROUND OF THE INVENTION

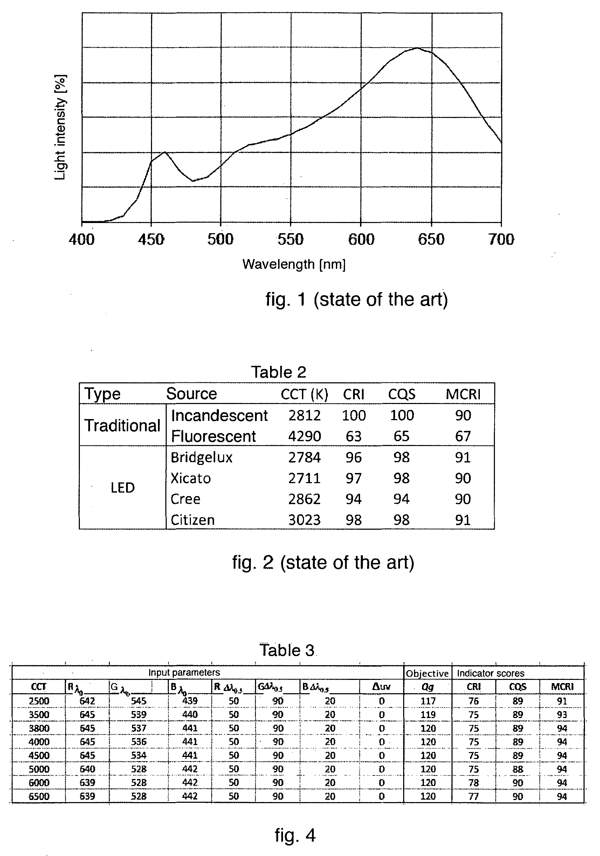

LED Arrays are known, which currently have the smallest bulk in the field of LED sources, but average flexibility in the definition of light emitted.
A LED Array is known, consisting of a matrix of LEDs which emit a blue light. The blue light is developed by a layer of chemical compound, which normally appears yellow, which allows to emit white light. The chemical compound can be present as such, or in combination with a suitable glass support.
For example, a so-called warm light has a spectrum as shown in fig. 1, where the two peaks are connected with the blue and the red, since the red peak prevails over the blue peak.
In this case, the blue peak is comprised between 440nm and 460nm, while the red peak is comprised between 620nm and 680nm.
The spectrum as per fig. 1 corresponds to a warm white light of around 3000K.
The quality of the light emitted is defined both by the color temperature (K), synthetically CCT, and also by another indicator. Typically, a "warm" source has a CCT of <3200K and a high light intensity near the wavelengths relating to the color red. A "cold" source has a CCT of <4000K and a high light intensity near the wavelengths relating to the color blue.
The best known indicator, recognized by the International Commission on Illumination (CIE) is the CIE-CRI, also known as CRI (Color Rendering Index) even though, due to the deficiencies that have been shown over time regarding said index, especially in the field of LED sources, there are now new legislative proposals to measure the quality of light in a better way, also for LED light sources or other types.
There are various types of LED Arrays on the market, and Table 2 in fig. 2 compares some products, by some producers, based on indexes detected by Applicant. Table 2, apart from the CRI index, also shows the CQS (Color Quality Scale) and MCRI (Memory Color Rendering Index) indexes.
In Table 2, the light sources shown supply values that can be compared for all the indexes since their objective is to obtain a high CRI value, near 100, that is, a value approaching that of incandescent light. However, the objective of achieving a CRI value near to 100 with a current LED Array source, SingleChip, Multichip, or OLEDs, in practice determines a distortion of the color and hence an unpleasant light is obtained for the user.
LEDs are also known for the emission of white light which have a spectrum of light emission provided with emission peaks located near to the wavelengths of 450nm, 535nm and 630nm, corresponding respectively to the colors blue, green and red. A light emission with these peaks allows the human eye to perceive the various colors with great sensitivity and with a good balance.
Light sources having emission spectrums with three peaks are described for example in documents US-A-2009/0154195, US-A-2009/0261710 and US-A-2007/0170842.
US-A-2009/0154195 concerns LED light sources for liquid crystal panels and describes spectrums of light emission with a very accentuated peak in correspondence with the red, and with very limited spectral amplitudes of the other peaks too, less than 50nm. Although it is very effective for the particular application to liquid crystal panels, this configuration of the spectrum does not allow it to be applied directly to other types of application, such as for example lighting for rooms.
In US-A-2009/0261710 the spectrums of light emission proposed have big spectral amplitudes, and consequently a great saturation of the colors perceived and not a natural perception.
US-A-2007/0170842 describes a light source consisting of a basic blue LED on which layers of phosphorus are positioned so as to modify the spectrum of light emission to generate three peaks of light emission. The formulations of spectrums of light emission expressed in this document entail a high distortion of the perception of the colors and therefore the light is not pleasant to see. Moreover, the combination of intensity of the peaks proposed in this document entails making light sources with low light efficiency.
Using spectrums of light emission with the characteristics expressed in the documents described above can be acceptable only for certain CCTs, but does not satisfy a wide range of applications. In fact, in the case of high CCTs the cold colors are distorted while for limited CCTs the warm colors are distorted.

For example, a "warm" source has a CCT of <3200K and a high light intensity near the wavelengths relating to red. A light source of this type allows a user to perceive the warm colors with an excellent quality, while the cold colors, for example blue, are greatly distorted.

A "cold" source has a CCT of >4000K and a high light intensity near the wavelengths relating to blue, and consequently the cold colors are reproduced with an excellent quality while the warm colors are distorted.

The Applicant set himself the purpose, using LED sources, of obtaining a pleasant light near to or the same as natural light, which is an improvement on the light emitted by an incandescent, fluorescent or halogen bulb, even if the indicators do not correspond to the CRI value of 100.

Another purpose of the present invention is to obtain a LED type light source that has an emission close to the natural one and with colors that are not distorted.

Another purpose of the present invention is to obtain a pleasant light having beautiful cold colors but able to enhance warm colors too, so as to satisfy, with a single lighting body, a wide range of the market.

Another purpose of the present invention is to obtain a light that enhances the attractiveness and vividness of the objects exposed to this light.

The Applicant has devised, tested and embodied the present invention to overcome the shortcomings of the state of the art and to obtain these and other purposes and advantages.

## SUMMARY OF THE INVENTION

The present invention is set forth and characterized in the main claim,while the dependent claims describe other characteristics of the present invention or variants of the main inventive idea.

In accordance with the above purposes, and in order to obtain a pleasant light, Applicant has studied, experimented with and obtained a series of reference curves relating to light emission spectrums such that the result is close to or the same as that sought.

According to a first formulation of the invention, a spectral curve of a LED light source with a pleasant light has three peaks. In this case the three peaks are disposed in correspondence respectively to the emission of a blue, green and red light source.

According to a variant, a spectral curve with a pleasant light has four peaks that correspond respectively to the emission of a blue, green, yellow and red light source.

The resulting basic spectral curve is the integral of the three Gaussian curves of the three spectrums so as to obtain a high color saturation.

According to the invention, the spectral curves were made for color temperatures CCT of the emission spectrum 10 comprised between 2500K and 6500K, since Applicant maintains that these limits are the most suitable for normal use light.

According to one possible formulation of the present invention, the emission spectrum provides that:

- the peak relating to the red color (R) is disposed in correspondence to a wavelength ($R\lambda_0$) comprised between 635nm and 648nm and has a spectral amplitude ($R\Delta\lambda_{0,5}$) comprised between 45nm and 55nm;
- the peak (G) relating to the green color is disposed in correspondence to a wavelength ($G\lambda_0$) comprised between 525nm and 545nm, and has a spectral amplitude ($G\Delta\lambda_{0,5}$) comprised between 85nm and 95nm;
- the peak (B) relating to the blue color is disposed in correspondence to a wavelength ($B\lambda_0$) comprised between 438nm and 445nm and has a spectral amplitude ($B\Delta\lambda_{0,5}$) comprised between 20nm and 25nm.

The correlation of the parameters of the emission spectrum as identified above allows to identify a plurality of spectral curves that solve the problems known in the state of the art, making the beam of light pleasant to the human eye without distorting the colors, that is, making it possible, at a determinate CCT, to keep the ratio between the reproduction of warm colors and cold colors, and the corresponding white point, correct.

According to another feature of the invention, the curves of the emission spectrums have a limited maximum value of saturation Qg "Relative Gamut Area" <= 125 so as to enhance the saturation of the colors, making them more pleasing and closer to a natural light.

Some forms of embodiment of the present invention provide that the limited maximum value of saturation Qg is less than 125, preferably comprised between 105 and 125, still more preferably between 107 and 118.

According to the invention, acting on the LED source proper and/or on the layer of chemical compound laid upon it, the desired spectral curves are obtained in relation to the CCT factor chosen.

According to another feature of the invention, it is possible to identify a plurality of spectral curves having the characteristics set forth by Applicant which are contained inside the two limit spectral curves, as finalized by Applicant.

According to another feature of the invention, the plurality of curves has a limit color temperature CCT of 2500K and 6500K.

According to the invention, if a phosphorus-based chemical compound that makes up the elaboration layer of the blue color is used, the chemical compound is adapted on each occasion to obtain the desired spectral line in relation to the desired CCT factor.

According to the invention, the elaboration layer can be applied to a glass support or it can incorporate glass powder.

The elaboration layer according to the invention can be a sintered inorganic powder containing, or not containing, inorganic phosphorus powder plus other components in relation to the curve to be obtained.

BRIEF DESCRIPTION OF THE DRAWINGS

These and other characteristics of the present invention will become apparent from the following description of one form of embodiment, given as a non-restrictive example with reference to the attached drawings wherein:

- fig. 1 is a graphical representation of the light emission spectrum relating to a warm LED Array source of a known type;
- fig. 2 refers to Table 2, in which some light sources of a known type are compared;
- fig. 3 refers to an emission spectrum of a light source according to the present invention;
- fig. 4 refers to Table 3 which shows parameters relating to the emission spectrums of light sources according to the present invention;
- fig. 5 is a graphical representation of emission spectrums of light sources according to the invention, which delimit minimum and maximum extremes of the normalized spectrums;
- fig. 6 refers to Table 4 which shows parameters of the emission spectrums in fig. 5.

It is understood that elements and characteristics of one form of embodiment can conveniently be incorporated into other forms of embodiment without further clarifications.

DETAILED DESCRIPTION OF SOME FORMS OF EMBODIMENT

A light source with a pleasant light of the LED Array type comprises at least a matrix of LEDs that emits a substantially blue light.

Above the LED matrix a film of materials is applied which allow to define a determinate spectrum of light emission.

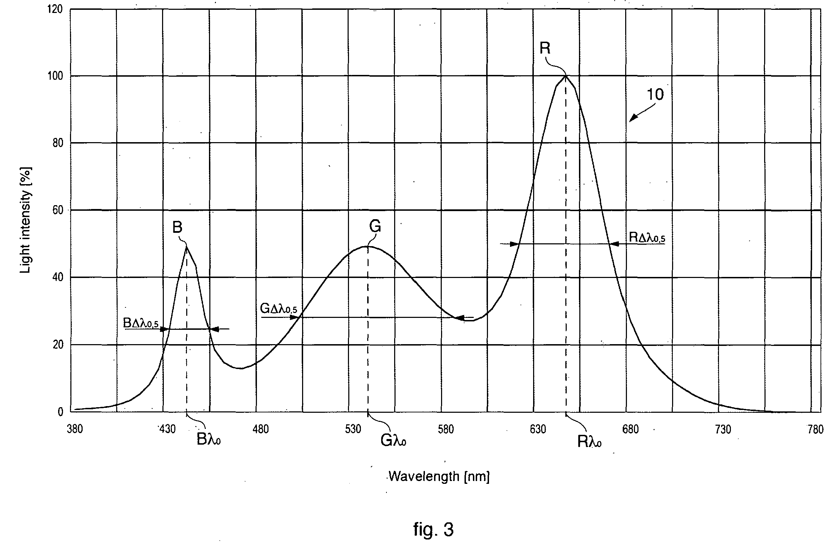

With reference to fig. 3, a spectrum of light emission of a pleasant light source according to the present invention is indicated in its entirety by the reference number 10 and is defined by a curve that can be represented in a Cartesian graph which has the wavelength $\lambda$ on the x-axis, expressed in nanometers, and the normalized light intensity I on the y-axis. The light intensity is considered normalized in that it depends on the distance at which the sampling is carried out. Some forms of embodiment provide that the normalization is the percentage type, on a scale from 0 to 100.

The emission spectrum 10 in fig. 3 allows to obtain a light source with a color temperature CCT of 3800K.

The curve of the emission spectrum 10 is defined substantially by overlapping three Gaussian curves.

The emission spectrum 10 has three peaks, indicated respectively as B, G and R, which are disposed in correspondence with the wavelengths relating respectively to the colors blue, green and red. The wavelengths for which the maximum value of light intensity is obtained, in relation to the three peaks B, G and R, is indicated with $\lambda_0$. Moreover, for each bell curve relating to the components blue, green and red a spectral amplitude $\Delta\lambda_{0,5}$ is identified, to which the value of the ordinate is equal to half its maximum peak value.

In the emission spectrum 10 the following parameters are also identifiable:

- $B\lambda_0$: wavelength (expressed in nm) in which the peak relating to the blue component is disposed, in this case at 441nm, to which a light intensity of about 50% corresponds;
- $G\lambda_0$: wavelength (expressed in nm) in which the. peak relating to the green component is disposed, in this case at 537nm, to which a light intensity of about 50% corresponds;
- $R\lambda_0$: wavelength (expressed in nm) in which the peak relating to the red component is disposed, in this case at 645nm, to which a light intensity of about 100% corresponds.

For each peak of the emission spectrum 10 it is also possible to determine:

- $B\Delta\lambda_{0,5}$: spectral amplitude, also identifiable by the acronym "FWHM" (Full Width at Half Maximum) of the Gaussian relating to the blue component at which the value of the ordinate is equal to half its maximum value, in this case 20nm. In practice it identifies the amplitude of the Gaussian "bell curve";

- $G\Delta\lambda_{0,5}$: spectral amplitude of the Gaussian relating to the green component at which the value of the ordinate is equal to half its maximum value, in this case 90nm;
- $R\Delta\lambda_{0,5}$: spectral amplitude of the Gaussian relating to the red component at which the value of the ordinate is equal to half its maximum value, in this case 50nm.

Another parameter relating to the emission spectrum 10 is the chromatic distance ($\Delta$uv), that is, the chromatic distance between the white point of the desired source and the white point of a black body radiating at the same value of the CCT index. It is a Cartesian distance inside the CIE 1976 (L*, u*, v*) color space, also called CIELUV.

The development of the light emission spectrum 10 is therefore defined by a function like:

$$S(\lambda) = F_R(\lambda) + F_G(\lambda) + F_B(\lambda)$$

where $F_R$, $F_G$, $F_B$ are functions of the individual components relating to the red, green and blue emission.

In some forms of embodiment, each of the functions $F_R$, $F_G$, $F_B$ are also correlated to a multiplicative factor, respectively $P_R$, $P_G$, $P_B$, which allow to define the Peak Power Ratios of each of the components, that is to say:

$$F_R(\lambda) = P_R \cdot S_R(\lambda) \qquad F_R(\lambda) = P_R \cdot S_R(\lambda) \qquad F_B(\lambda) = P_B \cdot S_B(\lambda)$$

The multiplicative factors $P_R$, $P_G$, $P_B$ express the proportionality between the various red, green and blue components of the spectrum, equalized with respect to the green peak $P_G$, whose value is always 1, while $S_R$, $S_G$, $S_B$ express respectively the development of the emission spectrum for each of the red, green and blue components.

Each of $S_R$, $S_G$, $S_B$ has a development close to that of a Gaussian, and can be expressed by the formula;

$$S_{R,G,B}(\lambda,\lambda_0,\Delta\lambda_{0,5}) = \left\{ g(\lambda,\lambda_0,\Delta\lambda_{0,5}) + 2 \cdot g^5(\lambda,\lambda_0,\Delta\lambda_{0,5}) \right\} / 3$$

wherein

$$g(\lambda,\lambda_0,\Delta\lambda_{0,5}) = \exp\left\{ -\left[ (\lambda - \lambda_0)/\lambda_{0,5} \right]^2 \right\}$$

In accordance with some forms of embodiment of the present invention it is possible to define a plurality of spectral curves that allow to obtain the purposes of the present invention.

With reference to Table 3 in fig. 4, the numerical values of the parameters $B\lambda_0$, $G\lambda_0$, $R\lambda_0$ and $B\Delta\lambda_{0,5}$, $G\Delta\lambda_{0,5}$, $R\Delta\lambda_{0,5}$ are indicatively shown, for emission spectrums having a range of color temperatures CCT variable from 2500K to 6500K.

These values are obtained by supplying a $\Delta$uv near to zero, in this case equal to zero. By $\Delta$uv value near to zero we mean a value comprised in a tolerance range of $\pm$ 0,0054. This limit is set by calculating the CRI index. A variation in the $\Delta$uv near to zero determines a variation, albeit limited, of the development of the curves provided by the present invention.

Some forms of embodiment of the present invention provide that the emission spectrum has a saturation value Qg less than 125. A variation in the saturation value Qg allows to obtain a greater or lesser enhancement of the colors.

Table 3 also shows the values detected by the indicators CRI, CQS and MCRI as identified above. As will be seen, the emission spectrums identified by Applicant give low scores, rather distant from 100, for the CRI, but high scores for CQS and MCRI.

These values of the indicators show that spectral curves of light emission are obtained that have a light which is neither too warm nor too cold. In fact, high values of the MCRI index confirm that a very pleasant light source is obtained.

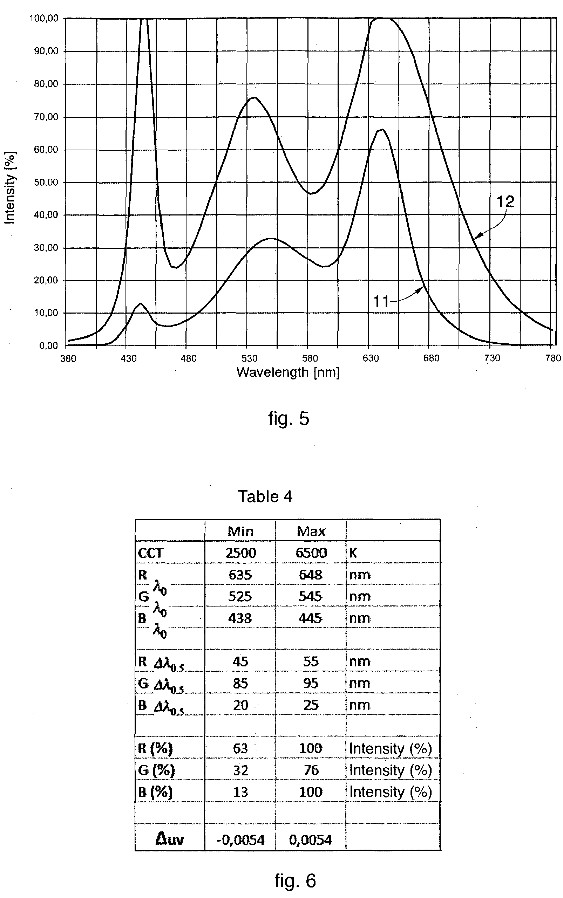

With reference to fig. 5, the plurality of spectral curves is contained within a first lower emission spectrum 11, and a second upper emission spectrum 12, which respectively delimit the minimum and maximum parameters of the emission spectrums. In other words, the first emission spectrum 11 and the second emission spectrum 12 delimit the zone which contains one of the curves of the spectrums according to the present invention.

With reference to Table 4 in fig. 6, this shows the minimum and maximum values corresponding respectively to the first emission spectrum 11 and the second emission spectrum 12, inside which all the other emission spectrums are evaluated.

Some forms of embodiment of the present invention provide that the emission spectrums have a parameter of CRI$\geq$ 50, preferably CRI$\geq$ 75.

Other forms of embodiment provide that the curve of the emission spectrum has four peaks that correspond respectively to the emission of a blue, green, yellow and red light source, with the yellow peak being interposed between the green and red peaks.

It is clear that modifications and/or additions of parts may be made to the light source with a pleasant light as described heretofore, without departing from the field and scope of the present invention.

It is also clear that, although the present invention has been described with reference to some specific examples, a person of skill in the art shall certainly be able to achieve many other equivalent forms of light source with a pleasant light, having the characteristics as set forth in the claims and hence all coming within the field of protection defined thereby.

**Claims**

1. Light source with a pleasant light, similar to natural light, for LEDs, such as LED Arrays, SingleChip or Multichip LEDs, OLEDs and remote phosphor LEDs, having an emission spectrum (10), with a color temperature CCT comprised between 2500K and 6500K, defined by a curve that is a function of the wavelength ($\lambda$) and light intensity (I) and provided with three emission peaks (R, G, B) disposed in correspondence to the wavelengths ($\lambda$) that are at least relative respectively to the colors red, green and blue, **characterized in that**

   - the peak (R) relating to the red color is disposed in correspondence to a wavelength ($R\lambda_0$) comprised between 635nm and 648nm and has a spectral amplitude ($R\Delta\lambda_{0,5}$) comprised between 45nm and 55nm;
   - the peak (G) relating to the green color is disposed in correspondence to a wavelength ($G\lambda_0$) comprised between 525nm and 545nm, and has a spectral amplitude ($G\Delta\lambda_{0,5}$) comprised between 85nm and 95nm;
   - the peak (B) relating to the blue color is disposed in correspondence to a wavelength ($B\lambda_0$) comprised between 438nm and 445nm and has a spectral amplitude ($B\Delta\lambda_{0,5}$) comprised between 20nm and 25nm.

2. Light source as in claim 1, **characterized in that** the peak (R) relating to the red color has a normalized_light intensity comprised between 63% and 100%.

3. Light source as in claim 1 or 2, **characterized in that** the peak (G) relating to the green color has a normalized light intensity comprised between 32% and 76%.

4. Light source as in any claim hereinbefore, **characterized in that** the peak (B) relating to the blue color has a normalized light intensity comprised between 13% and 100%.

5. Light source as in any claim hereinbefore, **characterized in that** said emission spectrum (10) has a saturation value (Qg) of less than 125, preferably between 105 and 125, even more preferably between 107 and 118.

6. Light source as in any claim hereinbefore, **characterized in that** said emission spectrum has a chromatic distance ($\Delta$uv) comprised between $\pm$ 0.0054.

7. Light source as in any claim hereinbefore, **characterized in that** said emission spectrum (10) has another peak disposed in correspondence to the wavelength ($\lambda$) relating to the color yellow.

8. Light source as in any claim hereinbefore, **characterized in that** said LED is elaborated with an elaboration layer comprising at least one of either a phosphorus-based chemical compound or a sintered inorganic powder.

9. Light source as in claim 8, **characterized in that** said elaboration layer is applied on a glass support or incorporates glass powder.

**Patentansprüche**

1. Lichtquelle mit einem angenehmen Licht, das dem natürlichen Licht ähnlich ist, für LEDs, wie LED Arrays, Ein-Chip- oder Multichip LEDs, OLEDs und Remote-Phosphor-LEDs, mit einem Emissionsspektrum (10), mit einer Farbtemperatur CCT zwischen 2500K und 6500K, definiert von einer Kurve, die eine Funktion der Wellenlänge ($\lambda$) und der

Lichtstärke (I) ist, und mit drei Emissionsspitzen (R, G, B) versehen, die in Übereinstimmung mit den Wellenlängen ($\lambda$) angeordnet sind, die sich jeweils zumindest auf die Farben Rot, Grün und Blau beziehen, **dadurch gekennzeichnet, dass**

- die Spitze (R) bezüglich der Farbe Rot in Übereinstimmung mit einer Wellenlänge ($R\lambda_0$) zwischen 635nm und 648nm angeordnet ist und eine Spektralamplitude ($R\Delta\lambda_{0,5}$) zwischen 45nm und 55nm aufweist;
- die Spitze (G) bezüglich der Farbe Grün in Übereinstimmung mit einer Wellenlänge ($G\lambda_0$) zwischen 525nm und 545nm angeordnet ist und eine Spektralamplitude ($G\Delta\lambda_{0,5}$) zwischen 85nm und 95nm aufweist;
- die Spitze (B) bezüglich der Farbe Blau in Übereinstimmung mit einer Wellenlänge ($B\lambda_0$) zwischen 438nm und 445nm angeordnet ist und eine Spektralamplitude ($B\Delta\lambda_{0,5}$) zwischen 20nm und 25nm aufweist.

2. Lichtquelle nach Anspruch 1, **dadurch gekennzeichnet, dass** die Spitze (R) bezüglich der Farbe Rot eine normierte Lichtstärke zwischen 63% und 100% aufweist.

3. Lichtquelle nach Anspruch 1 oder 2, **dadurch gekennzeichnet, dass** die Spitze (G) bezüglich der Farbe Grün eine normierte Lichtstärke zwischen 32% und 76% aufweist.

4. Lichtquelle nach einem der vorhergehenden Ansprüche, **dadurch gekennzeichnet, dass** die Spitze (B) bezüglich der Farbe Blau eine normierte Lichtstärke zwischen 13% und 100% aufweist.

5. Lichtquelle nach einem der vorhergehenden Ansprüche, **dadurch gekennzeichnet, dass** das genannte Emissionsspektrum (10) einen Sättigungswert (Qg) von weniger als 125, bevorzugt zwischen 105 und 125, und noch bevorzugter zwischen 107 und 118 aufweist.

6. Lichtquelle nach einem der vorhergehenden Ansprüche, **dadurch gekennzeichnet, dass** das genannte Emissionsspektrum einen chromatischen Abstand ($\Delta$uv) zwischen $\pm$ 0,0054 aufweist.

7. Lichtquelle nach einem der vorhergehenden Ansprüche, **dadurch gekennzeichnet, dass** das genannte Emissionsspektrum (10) eine andere Spitze aufweist, die in Übereinstimmung mit der Wellenlänge ($\lambda$) bezüglich der Farbe Gelb angeordnet ist.

8. Lichtquelle nach einem der vorhergehenden Ansprüche, **dadurch gekennzeichnet, dass** die genannte LED mit einer Bearbeitungsschicht bearbeitet ist, die zumindest eine bzw. ein aus einer phosphor-basierten chemischen Verbindung oder einem gesinterten anorganischen Pulver umfasst.

9. Lichtquelle nach Anspruch 8, **dadurch gekennzeichnet, dass** die genannte Bearbeitungsschicht auf eine Glasunterlage aufgetragen wird oder Glaspulver enthält.

**Revendications**

1. Source de lumière à lumière agréable, proche à la lumière naturelle, pour des DEL, comme des matrices de DEL, des DEL à puce unique ou à puces multiples, des ODEL et des DEL au phosphore différé, ayant un spectre d'émission (10) défini par une température de couleur corrélée (Correlated Color Temperature, CCT) comprise entre 2500 K et 6500 K, défini par une courbe qui est fonction de la longueur d'onde ($\lambda$) et de l'intensité lumineuse (I) et pourvu de trois pics d'émission (R, G, B) disposés au niveau des longueurs d'onde ($\lambda$) qui sont au moins respectivement relatives aux couleurs rouge, verte et bleue, **caractérisée en ce que**

- le pic (R) relatif à la couleur rouge se trouve au niveau d'une longueur d'onde ($R\lambda_0$) comprise entre 635 nm et 648 nm et présente une amplitude spectrale ($R\Delta\lambda_{0,5}$) comprise entre 45 nm et 55 nm ;
- le pic (G) relatif à la couleur verte se trouve au niveau d'une longueur d'onde ($G\lambda_0$) comprise entre 525 nm et 545 nm et présente une amplitude spectrale ($G\Delta\lambda_{0,5}$) comprise entre 85 nm et 95 nm ;
- le pic (B) relatif à la couleur bleue se trouve au niveau d'une longueur d'onde ($B\lambda_0$) comprise entre 438 nm et 445 nm et présente une amplitude spectrale ($B\Delta\lambda_{0,5}$) comprise entre 20 nm et 25 nm ;

2. Source de lumière selon la revendication 1, **caractérisée en ce que** le pic (R) relatif à la couleur rouge a une intensité de lumière normalisée comprise entre 63% et 100%.

**3.** Source de lumière selon la revendication 1 ou 2, **caractérisée en ce que** le pic (G) relatif à la couleur verte a une intensité de lumière normalisée comprise entre 32% et 76%.

**4.** Source de lumière selon n'importe laquelle des revendications précédentes, **caractérisée en ce que** le pic (B) relatif à la couleur bleue a une intensité de lumière normalisée comprise entre 13% et 100%.

**5.** Source de lumière selon n'importe laquelle des revendications précédentes, **caractérisée en ce que** ledit spectre d'émission (10) a une valeur de saturation (Qg) de moins de 125, de préférence comprise entre 105 et 125, de préférence encore entre 107 et 118.

**6.** Source de lumière selon n'importe laquelle des revendications précédentes, **caractérisée en ce que** ledit spectre d'émission a une distance chromatique ($\Delta$uv) comprise entre $\pm$ 0.0054.

**7.** Source de lumière selon n'importe laquelle des revendications précédentes, **caractérisée en ce que** ledit spectre d'émission (10) comporte un autre pic au niveau de la longueur d'onde ($\lambda$) relative à la couleur jaune.

**8.** Source de lumière selon n'importe laquelle des revendications précédentes, **caractérisée en ce que** ladite DEL est élaborée avec une couche d'élaboration comprenant au moins un d'un composé chimique à base de phosphore ou une poudre inorganique frittée.

**9.** Source de lumière selon la revendication 8, **caractérisée en ce que** ladite couche d'élaboration est appliquée sur un support de verre ou contient du verre en poudre.

fig. 1 (state of the art)

Table 2

| Type | Source | CCT (K) | CRI | CQS | MCRI |
|------|--------|---------|-----|-----|------|
| Traditional | Incandescent | 2812 | 100 | 100 | 90 |
| | Fluorescent | 4290 | 63 | 65 | 67 |
| LED | Bridgelux | 2784 | 96 | 98 | 91 |
| | Xicato | 2711 | 97 | 98 | 90 |
| | Cree | 2862 | 94 | 94 | 90 |
| | Citizen | 3023 | 98 | 98 | 91 |

fig. 2 (state of the art)

Table 3

| Input parameters | | | | | | | Objective | Indicator scores | | |
|------|------|------|------|------|------|------|------|------|------|------|
| CCT | $R_{\lambda_0}$ | $G_{\lambda_0}$ | $B_{\lambda_0}$ | $R\,\Delta\lambda_{0.5}$ | $G\Delta\lambda_{0.5}$ | $B\Delta\lambda_{0.5}$ | $\Delta uv$ | $Qg$ | CRI | CQS | MCRI |
| 2500 | 642 | 545 | 439 | 50 | 90 | 20 | 0 | 117 | 76 | 89 | 91 |
| 3500 | 645 | 539 | 440 | 50 | 90 | 20 | 0 | 119 | 75 | 89 | 93 |
| 3800 | 645 | 537 | 441 | 50 | 90 | 20 | 0 | 120 | 75 | 89 | 94 |
| 4000 | 645 | 536 | 441 | 50 | 90 | 20 | 0 | 120 | 75 | 89 | 94 |
| 4500 | 645 | 534 | 441 | 50 | 90 | 20 | 0 | 120 | 75 | 89 | 94 |
| 5000 | 640 | 528 | 442 | 50 | 90 | 20 | 0 | 120 | 75 | 88 | 94 |
| 6000 | 639 | 528 | 442 | 50 | 90 | 20 | 0 | 120 | 78 | 90 | 94 |
| 6500 | 639 | 528 | 442 | 50 | 90 | 20 | 0 | 120 | 77 | 90 | 94 |

fig. 4

fig. 3

EP 2 901 502 B1

fig. 5

Table 4

| | Min | Max | |
|---|---|---|---|
| CCT | 2500 | 6500 | K |
| R $\lambda_0$ | 635 | 648 | nm |
| G $\lambda_0$ | 525 | 545 | nm |
| B $\lambda_0$ | 438 | 445 | nm |
| | | | |
| R $\Delta\lambda_{0.5}$ | 45 | 55 | nm |
| G $\Delta\lambda_{0.5}$ | 85 | 95 | nm |
| B $\Delta\lambda_{0.5}$ | 20 | 25 | nm |
| | | | |
| R (%) | 63 | 100 | Intensity (%) |
| G (%) | 32 | 76 | Intensity (%) |
| B (%) | 13 | 100 | Intensity (%) |
| | | | |
| $\Delta$uv | -0,0054 | 0,0054 | |

fig. 6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20090154195 A
- US 20090261710 A
- US 20070170842 A